(19) Europäisches Patentamt
European Patent Office
Office européen des brevets

(11) **EP 3 451 072 B1**

(12) **FASCICULE DE BREVET EUROPEEN**

(45) Date de publication et mention
de la délivrance du brevet:
**25.10.2023 Bulletin 2023/43**

(51) Classification Internationale des Brevets (IPC):
**G04B 17/04** *(2006.01)* **G04B 17/28** *(2006.01)*
**G04B 31/02** *(2006.01)* **B81B 3/00** *(2006.01)*

(21) Numéro de dépôt: **17188264.0**

(52) Classification Coopérative des Brevets (CPC):
**G04B 17/045; B81B 3/0045; G04B 17/28;
G04B 31/02**

(22) Date de dépôt: **29.08.2017**

(54) **PIVOT ISOCHRONE POUR RESONATEUR D'HORLOGERIE**

ISOCHRONES DREHGELENK FÜR UHRRESONATOR

ISOCHRONOUS PIVOT FOR TIMEPIECE RESONATOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**06.03.2019 Bulletin 2019/10**

(73) Titulaire: **The Swatch Group Research and
Development Ltd
2074 Marin (CH)**

(72) Inventeurs:
• **DI DOMENICO, Gianni
2000 Neuchâtel (CH)**
• **LECHOT, Dominique
2722 Les Reussilles (CH)**

• **FAVRE, Jérôme
2000 Neuchâtel (CH)**
• **HINAUX, Baptiste
1005 Lausanne (CH)**
• **BORN, Jean-Jacques
1110 Morges (CH)**
• **HELFER, Jean-Luc
2525 Le Landeron (CH)**
• **WINKLER, Pascal
2072 St-Blaise (CH)**

(74) Mandataire: **ICB SA
Faubourg de l'Hôpital, 3
2001 Neuchâtel (CH)**

(56) Documents cités:
**EP-A1- 3 021 174 EP-A1- 3 206 089
FR-A- 1 502 775 US-A1- 2017 227 930**

**Description**

<u>Domaine de l'invention</u>

L'invention concerne un pivot isochrone pour résonateur d'horlogerie, à guidage flexible, comportant au moins un couple comportant deux lames flexibles joignant chacune un premier encastrement d'un premier élément à un deuxième encastrement d'un deuxième élément, lesdits premiers encastrements définissant avec lesdits deuxièmes encastrements respectifs deux directions principales de lames, ledit premier élément et ledit deuxième élément étant chacun plus rigide que chacune desdites lames flexibles, et chacun apte à constituer un élément inertiel mobile au sein d'un dit résonateur, et lesdites deux directions principales de lames définissant un axe de pivotement théorique, à leur croisement quand lesdites deux lames flexibles sont coplanaires, ou au croisement de leurs projections sur un plan de référence parallèle auxdites deux lames flexibles quand lesdites deux lames flexibles se développent sur deux niveaux parallèles audit plan de référence mais ne sont pas coplanaires, chaque dite lame flexible ayant une longueur libre entre ses deux encastrements, et ayant une distance axiale entre ledit axe de pivotement théorique et celui de ses dits deux encastrements qui en est le plus éloigné, et où, pour chaque dite lame flexible, le rapport d'encastrement principal $X=D/L$ entre ladite distance axiale et ladite longueur libre est supérieur à un, et où lesdites deux directions principales de lames définissent avec ledit axe de pivotement théorique un premier angle au sommet $\alpha$ dont la valeur en degrés satisfait la relation $f1(X) <\alpha<f2(X)$, avec $f1(X)= 108 + 67/(10X-6)$, et $f2(X)= 113 + 67/(10X-6)$.

L'invention concerne encore un résonateur comportant un premier élément et un deuxième élément joints par au moins un couple comportant deux lames flexibles que comporte un tel pivot.

L'invention concerne encore un mouvement d'horlogerie comportant au moins un tel résonateur.

L'invention concerne encore une montre comportant au moins un tel mouvement.

<u>Arrière-plan de l'invention</u>

L'utilisation de guidages flexibles, notamment à lames souples, dans des oscillateurs mécaniques d'horlogerie, est rendue possible par des procédés d'élaboration, tels que « MEMS », « LIGA » ou similaires, de matériaux micro-usinables, tels que le silicium et ses oxydes, qui permettent une fabrication très reproductible de composants qui présentent des caractéristiques élastiques constantes dans le temps et une grande insensibilité aux agents extérieurs tels que température et humidité. Des pivots à guidage flexible, tels que décrits dans les demandes EP3035126A1 ou EP3206089A1 du même déposant, permettent notamment de remplacer le pivot d'un balancier classique, ainsi que le ressort-spiral qui lui est usuellement associé. La suppression des frottements de pivots permet d'augmenter substantiellement le facteur de qualité d'un oscillateur.

Toutefois, les pivots à guidage flexibles sont connus pour avoir une force de rappel élastique non linéaire, et un mouvement parasite de l'axe instantané de rotation.

Les travaux de Wittrick en 1951 ont permis la réduction du déplacement parasite par positionnement du point de croisement des lames aux sept huitièmes de leur longueur. La demande EP3035126A1 du même déposant propose, en combinaison avec cette disposition, le choix d'un angle au sommet particulier entre les lames, pour optimiser la linéarité de la force de rappel élastique, pour rendre le résonateur isochrone.

Un tel pivot comportant deux lames croisées en projection ne peut toutefois pas être gravé en une seule fois en deux dimensions, ce qui complique sa fabrication.

La demande EP3206089A1 du même déposant SWATCH GROUP RESEARCH & DEVELOPMENT Ltd propose une géométrie 2D réalisable sur un seul niveau de gravure, et qui possède les avantages recherchés de linéarité et de faible déplacement parasite. Elle décrit un mécanisme résonateur d'horlogerie comportant un premier support avec un premier ancrage et un deuxième ancrage auxquels est fixé un mécanisme flexible de guidage en pivotement, qui définit un axe de pivotement virtuel autour duquel pivote de façon rotative une masse pivotante, et qui comporte au moins un pivot flexible RCC antérieur et un pivot flexible RCC postérieur montés en série et tête-bêche l'un par rapport à l'autre autour dudit axe de pivotement virtuel, ledit pivot flexible RCC antérieur comportant, entre ledit premier support et un support rotatif intermédiaire, deux lames flexibles antérieures droites de même longueur antérieure LA entre leurs encastrements, définissant deux directions linéaires antérieures qui se croisent au niveau dudit axe de pivotement virtuel et qui définissent avec ledit axe de pivotement virtuel un angle antérieur, et dont les ancrages respectifs desdites deux lames flexibles antérieures droites les plus éloignés dudit axe de pivotement virtuel sont tous deux à une même distance antérieure DA dudit axe de pivotement virtuel, et ledit pivot flexible RCC postérieur comportant, entre ledit support rotatif intermédiaire, qui comporte un troisième ancrage et un quatrième ancrage, et ladite masse pivotante, deux lames flexibles postérieures droites de même longueur postérieure LP entre leurs encastrements, définissant deux directions linéaires postérieures qui se croisent au niveau dudit axe de pivotement virtuel et qui définissent avec ledit axe de pivotement virtuel un angle postérieur, et dont les ancrages respectifs desdites deux lames flexibles postérieures droites les plus éloignés dudit axe de pivotement virtuel sont tous deux à une même distance postérieure DP dudit axe de pivotement virtuel. Ce mécanisme flexible de guidage en pivotement est plan, en le centre d'inertie de l'ensemble formé par ladite masse pivotante et toute masse inertielle rapportée que porte ladite masse pivotante est sur ledit axe de pivotement virtuel ou dans son voisinage immédiat, et ledit angle antérieur exprimé en degrés est compris entre :

$$109.5 + 5/[(DA/LA)-(2/3)] \text{ et } 114.5 + 5/[(DA/LA)-(2/3)]$$

et ledit angle postérieur exprimé en degrés est compris entre :

$$109.5 + 5/[(DP/LP)-(2/3)] \text{ et } 114.5 + 5/[(DP/LP)-(2/3)].$$

Résumé de l'invention

L'invention se propose de définir un résonateur à guidage flexible en rotation, qui soit isochrone, simple à fabriquer, et qui supporte des chocs sans pour autant dégrader un facteur de qualité élevé.
Plus particulièrement il s'agit d'optimiser l'exploitation d'un pivot de type RCC (Remote Compliance Center), avec lames formant un vé, et centre de rotation déporté, facile à fabriquer et robuste, pour remplir ce cahier des charges.
A cet effet, l'invention concerne un pivot isochrone pour résonateur d'horlogerie, à guidage flexible, selon la revendication 1.
L'invention concerne encore un résonateur comportant un premier élément et un deuxième élément joints par au moins un couple comportant deux lames flexibles que comporte un tel pivot, selon la revendication 13.
L'invention concerne encore un mouvement d'horlogerie comportant au moins un tel résonateur.
L'invention concerne encore une montre comportant au moins un tel mouvement.

Description sommaire des dessins

D'autres caractéristiques et avantages de l'invention apparaîtront à la lecture de la description détaillée qui va suivre, en référence aux dessins annexés, où :

- la figure 1A représente, de façon schématisée, et en vue en plan, les encastrements d'un pivot RCC à deux lames formant un vé, entre une base fixe, et un élément inertiel solide,
- la figure 1B représente, de façon similaire, les longueurs libres L et distances axiales D de ces lames, leur angle au sommet α, et leur point de croisement,
- la figure 2 est un graphe qui représente i'évolution de i'angie au sommet α optimum en ordonnée, en fonction du rapport X=D/L en abscisse, avec une zone d'isochronisme amélioré entre deux courbes, inférieure f1 et supérieure f2, de part et d'autre d'une courbe moyenne fm ,
- la figure 3 représente, de façon similaire à la figure 1, un pivot RCC similaire et comportant un oeil autour du point de croisement des lames ,
- la figure 4 représente, en coupe, la zone d'un oeil comme celui de la figure 3, qui entoure un noyau pourvu de deux masses d'arrêt faisant antichoc axial de part et d'autre de cet oeil ,
- la figure 5 représente, de façon similaire à la figure 4, la configuration inverse avec l'oeil muni d'au arbre mobile entre deux lamages inférieur et supérieur d'un élément fixe,
- la figure 6 représente, de façon similaire à la figure 1, la mise en série de deux pivots RCC avec chacun un angle optimum, avec l'élément inertiel comportant un tenon muni d'un oeil comme sur la figure 3, et comportant un contour de révolution borné par une chambre d'un élément intermédiaire suspendu à la base fixe par deux lames en sens contraire de celles liant l'élément inertiel à l'élément intermédiaire ,
- la figure 7 représente, de façon similaire à la figure 6, la mise en série de deux pivots RCC avec chacun un angle optimum, avec l'élément inertiel comportant un oeil comme sur la figure 3, et comportant un contour de révolution borné par une chambre de la base fixe, à laquelle est suspendu par deux lames en sens contraire un élément intermédiaire faisant cadre et auquel est suspendu l'élément inertiel,
- la figure 8 représente, de façon similaire à la figure 6, la mise en série de deux pivots RCC avec chacun un angle optimum, avec les lames disposées dans le même sens, mais avec deux angles au sommet différents, choisis au-dessus et en-dessous du milieu de la zone d'isochronisme amélioré ,
- la figure 9, analogue à la figure 2, montre le positionnement des deux angles de la figure 8 ,
- la figure 10 est un schéma-blocs qui représente une montre comportant un mouvement incorporant un résonateur muni d'un tel pivot,
- la figure 11, reprise de la demande EP14199039 du même déposant, illustre une configuration de pivot de résonateur à lames croisées non coplanaires.

Description détaillée des modes de réalisation préférés

L'invention concerne un pivot 1 isochrone pour résonateur 100 d'horlogerie, à guidage flexible, comportant au moins un couple dénommé génériquement 2, ou plus particulièrement un premier couple 21 ou un deuxième couple 22. Ce couple 2 comporte deux lames flexibles 3 : 31, 32, joignant chacune un premier encastrement 41, 42, d'un premier élément 4 à un deuxième encastrement 51, 52, d'un deuxième élément 5. Ces premiers encastrements 41, 42, définissent avec les deuxièmes encastrements 51, 52, respectifs deux directions principales de lames DL1 et DL2. Le premier élément 4 et le deuxième élément 5 sont chacun plus rigide que chacune des lames flexibles 3, et chacun est apte à constituer un élément inertiel mobile au sein d'un résonateur 100.

Les deux directions principales de lames DL1,DL2, définissant un axe de pivotement théorique A, à leur croisement quand les deux lames flexibles 31, 32, sont coplanaires, ou au croisement de leurs projections sur un plan de référence parallèle aux deux lames flexibles 31, 32, quand les deux lames flexibles 31, 32 ,se développent sur deux niveaux parallèles au plan de référence mais ne sont pas coplanaires.

Chaque lame flexible 31, 32, a une longueur dite libre L1, L2, entre ses deux encastrements 41, 51, 42, 52, et ayant une distance axiale D1, D2, entre l'axe de pivotement théorique A et celui de ses deux encastrements 41, 51, 42, 52, qui en est le plus éloigné.

Pour chaque lame flexible 31, 32, le rapport d'encastrement principal D1/L1, D2/L2 entre la distance axiale et la longueur libre est supérieur à un.

L'invention concerne encore un résonateur 100 comportant un premier élément 4 et un deuxième élément 5 joints par au moins un tel couple 2 comportant deux lames flexibles 31, 32, que comporte un tel pivot 1.

Selon l'invention, les deux directions principales de lames DL1, DL2, définissent avec l'axe de pivotement théorique A le premier angle au sommet $\alpha$, dont la valeur dépend du rapport d'encastrement principal D1/L1, D2/L2, entre une première fonction inférieure f1 telle que $\alpha$= f1(D/L), et une première fonction supérieure f2, telle que $\alpha$= f2(D/L), où

f1(X)= 108 + 67/(10X-6), et
f2(X)= 113 + 67/(10X-6), avec X= D/L.

Selon l'invention, D1/L1 = D2/L2 = D/L = X, et est plus grand que 1. La valeur en degrés du premier angle au sommet a satisfait alors la relation f1(D/L) <$\alpha$<f2(D/L), avec f1(D/L) = 108 + 67/(10X-6), et f2(D/L) = 113 + 67/(10X-6), avec X= D/L.

Selon l'invention, les deux directions principales de lames DL1 et DL2 définissent avec l'axe de pivotement théorique A un premier angle au sommet $\alpha$, qui est compris entre 115° et 130°, bornes comprises. Ceci revient à borner la valeur X= D/L entre les valeurs X=1 et X=1.55.

Plus particulièrement, l'axe de pivotement théorique A est situé géométriquement dans le premier élément 4 ou dans le deuxième élément 5.

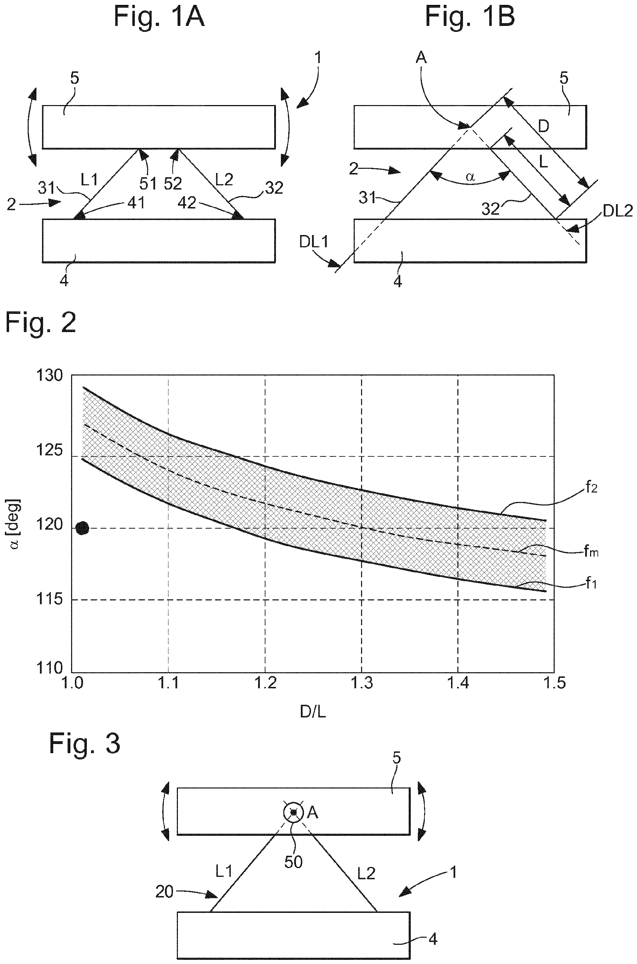

La figure 3 illustre le cas avantageux où l'axe de pivotement théorique A est situé géométriquement dans le deuxième élément 5.

Plus particulièrement cet axe de pivotement théorique A est situé géométriquement dans une ouverture dite oeil 40, 50, que comporte le premier élément 4 ou le deuxième élément 5.

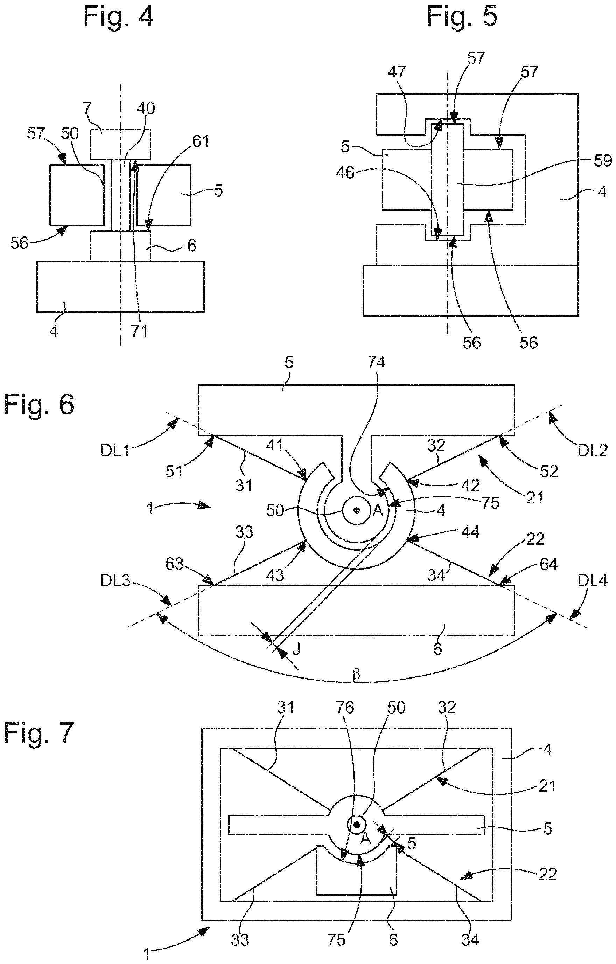

La figure 4 représente, en coupe, la zone d'un oeil 50 dans le deuxième élément inertiel 5, qui entoure un noyau 40, ici non limitativement solidaire du premier élément 4 qui constitue une masse fixe, et lequel noyau 40 est pourvu de deux masses d'arrêt 6 et 7 faisant antichoc axial de part et d'autre de cet oeil 50 et de l'élément inertiel 5, dont les surfaces inférieure 56 et supérieure 57 sont agencées pour coopérer en limitation de butée avec ces masses d'arrêt 6 et 7. La figure 5 illustre la configuration inverse avec l'oeil 50 muni d'un arbre 59 mobile entre deux lamages inférieur 46 et supérieur 47 d'un élément fixe 4, les extrémités 56 et 57 de cet arbre 59 étant agencées pour coopérer en limitation de butée avec ces lamages 46 et 47.

Plus particulièrement, le pivot 1 comporte au moins un couple 2 comportant deux lames flexibles 31, 32, qui sont, ou bien identiques en symétrie par rapport à un plan de symétrie passant par l'axe de pivotement théorique A quand les deux lames flexibles 31, 32, sont coplanaires, ou bien identiques en symétrie en projection sur un plan de référence parallèle aux deux lames flexibles 31, 32, quand les deux lames flexibles 31, 32,se développent sur deux niveaux parallèles au plan de référence mais ne sont pas coplanaires, par rapport à un plan de symétrie passant par l'axe de pivotement théorique A.

Plus particulièrement chaque couple 2, que comporte le pivot 1, comporte deux lames flexibles 31,32, qui sont, ou bien identiques en symétrie par rapport à un plan passant par l'axe de pivotement théorique A quand les deux lames flexibles 31, 32, sont coplanaires, ou bien identiques en symétrie en projection sur un plan de référence parallèle aux deux lames flexibles 31, 32, quand les deux lames flexibles 31, 32, se développent sur deux niveaux parallèles au plan de référence mais ne sont pas coplanaires.

Plus particulièrement le pivot 1 comporte au moins un couple 2 comportant deux lames flexibles 31, 32, qui sont coplanaires.

Plus particulièrement le pivot 1 comporte au moins un couple 2 comportant deux lames flexibles 31, 32, qui se développent sur deux niveaux parallèles au plan de référence mais ne sont pas coplanaires.

Plus particulièrement, le pivot 1 est symétrique, au moins en projection sur le plan de référence, par rapport à un plan de symétrie passant par l'axe de pivotement théorique A, et le centre de masse du résonateur 100 dans sa position de repos est situé géométriquement sur le plan de symétrie.

Avantageusement, on positionne le centre de masse du résonateur, dans sa position de repos, sur l'axe de symétrie du pivot, et à une faible distance de l'axe de rotation A défini par le point de croisement des prolongements des lames, ce qui a pour effet de compenser le déplacement parasite du pivot. Pour un pivot simple, la distance optimale dépend du rapport X=D/L. Ainsi le centre de masse du résonateur 100 dans sa position de repos est distant de l'axe de pivotement théorique A d'un écart $\varepsilon$ qui dépend des longueurs libres $L1$, $L2$, et des rapports d'encastrements $D1/L1$, $D2/L2$. Plus particulièrement $D1/L1 = D2/L2 = D/L = X$. Plus particulièrement encore $D1 = D2 = D$ et $L1 = L2 = L$, et cet écart $\varepsilon$ est sensiblement égal à la valeur $(2D^2/L - 1.6. D - 0.1 L)$. Plus particulièrement cet écart $\varepsilon$ est compris entre 0.8 fois et 1.2 fois la valeur $(2D^2/L - 1.6. D - 0.1 L)$.

Les pivots RCC tels que décrits ci-dessus peuvent être combinés de plusieurs façons. En particulier, les figures 6 à 8 illustrent des variantes non limitatives, résultant de différentes combinaisons de couples de lames.

Plus particulièrement le pivot 1 comporte ainsi, en plus d'un premier couple 21 comportant les deux lames flexibles 31, 32, joignant chacune un premier encastrement 41, 42, d'un premier élément 4 à un deuxième encastrement 51, 52, d'un deuxième élément 5, au moins un deuxième couple 22 comportant deux autres lames flexibles 33, 34, joignant chacune, d'une part un encastrement primaire 43, 44, du premier élément 4 ou un encastrement secondaire 53, 54, du deuxième élément 5, à d'autre part un encastrement tertiaire 63, 64, que comporte un troisième élément 6 agencé pour être fixé solidairement à une structure fixe du résonateur 100.

Plus particulièrement le premier élément 4 ou le deuxième élément 5 est un élément inertiel, et l'axe de pivotement théorique A est situé géométriquement dans un oeil 40, 50, que comporte cet élément inertiel. Les figures 6 à 8 comportent un tel oeil 50 dans l'élément inertiel 5.

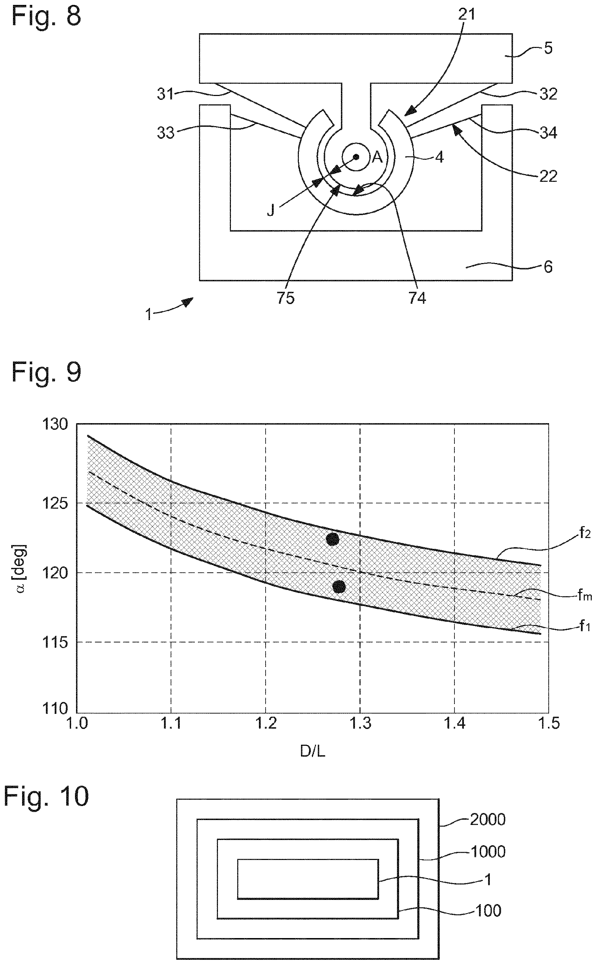

Plus particulièrement, tel que visible sur les figures 6 et 8, le premier élément 4 ou le deuxième élément 5 comporte une surface concave 74 agencée pour entourer à distance, sur au moins 180°, une surface convexe 75 que comporte le deuxième élément 5 ou respectivement le premier élément 4, avec, dans une position de repos du pivot 1, un jeu en tout point supérieur ou égal à un jeu de sécurité J entre la surface convexe 75 et la surface concave 74.

La figure 6 illustre la mise en série de deux pivots RCC avec chacun un angle optimum, avec l'élément inertiel 5 comportant un tenon muni d'un oeil 50, et comportant un contour partiellement de révolution 75 borné par une chambre 74 d'un élément intermédiaire 4 suspendu à la base fixe 6 par deux lames 33, 34, en sens contraire de celles 31, 32, liant l'élément inertiel 5 à l'élément intermédiaire 4.

Plus particulièrement, le premier élément 4 ou le deuxième élément 5 est un élément inertiel, et le troisième élément 6, notamment la base fixe, comporte une surface interne 76 agencée pour entourer à distance, sur au moins 180°, une surface convexe 75 que comporte l'élément inertiel, avec, dans une position de repos du pivot 1, un jeu en tout point supérieur ou égal à un jeu de sécurité J entre la surface convexe 75 et la surface interne 76.

La figure 7 concerne la mise en série de deux pivots RCC avec chacun un angle optimum, avec l'élément inertiel 5 comportant un oeil 50, et comportant un contour partiellement de révolution 75 borné par une chambre 76 de la base fixe 6, à laquelle est suspendu par deux lames 33, 34, en sens contraire un élément intermédiaire 4 faisant cadre et auquel est suspendu l'élément inertiel 5.

Selon un mode de réalisation de l'invention, tel que visible sur la figure 8, on met en série de deux pivots RCC avec chacun un angle optimum $\alpha$, $\beta$, différent, avec les lames disposées dans le même sens, mais avec deux angles au sommet différents, choisis au-dessus et en-dessous du milieu de la zone d'isochronisme amélioré : d'une part les encastrements primaires 43, 44, du premier élément 4 ou encastrements secondaires 53, 54, du deuxième élément 5, et d'autre part les encastrements tertiaires 63, 64, définissent deux directions secondaires de lames DL3, DL4, qui forment ensemble un deuxième angle au sommet $\beta$ au niveau d'un axe secondaire B défini par le croisement, en plan ou en projection, des directions secondaires de lames DL3, DL4. Ce deuxième angle au sommet $\beta$ est, comme le premier angle au sommet $\alpha$, compris entre 115° et 130°, bornes comprises, ou bien sa valeur dépend d'un rapport d'encastrement secondaire $D3/L3$, $D4/L4$, entre une première fonction inférieure f1 telle que $\beta = f1(D/L)$, et une première fonction supérieure f2, telle que $\beta = f2(D/L)$.

Selon l'invention et tel que visible sur la figure 9, une fonction médiane $fm(X) = 110.5 + 67/(10X-6)$ définit un rapport intermédiaire entre la première fonction inférieure $f1(X) = 108 + 67/(10X-6)$, et la première fonction supérieure $f2(X) = 113 + 67/(10X-6)$, avec $X = D/L$, et le premier angle au sommet $\alpha$ et le deuxième angle au sommet $\beta$ sont positionnés entre la première fonction inférieure f1 et la première fonction supérieure f2, de part et d'autre de la fonction médiane fm.

Plus particulièrement l'axe de pivotement théorique A est confondu avec l'axe secondaire B.

L'invention concerne encore un mouvement d'horlogerie 1000 comportant au moins un tel résonateur 100.

L'invention concerne encore une montre 2000 comportant un tel mouvement d'horlogerie 1000.

**Revendications**

1. Pivot (1) isochrone pour résonateur (100) d'horlogerie, à guidage flexible, comportant au moins un couple (21) comportant deux lames flexibles (31 , 32) joignant chacune un premier encastrement (41 , 42) d'un premier élément (4) à un deuxième encastrement (51 , 52) d'un deuxième élément (5), lesdits premiers encastrements (41 , 42) définissant avec lesdits deuxièmes encastrements (51 , 52) respectifs deux directions principales de lames (DL1 , DL2), ledit premier élément (4) et ledit deuxième élément (5) étant chacun plus rigide que chacune desdites lames flexibles (3), et chacun apte à constituer un élément inertiel mobile au sein d'un dit résonateur (100), et lesdites deux directions principales de lames (DL1 , DL2) définissant un axe de pivotement théorique (A), à leur croisement quand lesdites deux lames flexibles (31 , 32) sont coplanaires, ou au croisement de leurs projections sur un plan de référence parallèle auxdites deux lames flexibles (31 , 32) quand lesdites deux lames flexibles (31 , 32) se développent sur deux niveaux parallèles audit plan de référence mais ne sont pas coplanaires, chaque dite lame flexible (31 , 32) ayant une longueur libre (L1 , L2) entre ses deux encastrements (41 , 51 , 42 , 52), et ayant une distance axiale (D1 , D2) entre ledit axe de pivotement théorique (A) et celui de ses dits deux encastrements (41, 51 , 42, 52) qui en est le plus éloigné, et où, pour chaque dite lame flexible (31, 32), le rapport d'encastrement principal (D1/L1 , D2/L2) entre ladite distance axiale et ladite longueur libre est supérieur à un, où lesdites deux directions principales de lames (DL1 , DL2) définissent avec ledit axe de pivotement théorique (A) un premier angle au sommet (α) dont la valeur en degrés satisfait la relation f1(X$_α$) < α < f2(X$_α$),

   avec f1(X$_α$)=108+67/(10X$_α$-6), et f2(X$_α$)=113+67/(10X$_α$-6), avec X$_α$=D1/L1=D2/L2,
   où lesdites deux directions principales de lames (DL1 , DL2) définissent avec ledit axe de pivotement théorique (A) un premier angle au sommet (α) compris entre 115° et 130°, bornes comprises, et où ledit pivot (1) comporte, en plus d'un premier couple (21) comportant lesdites deux lames flexibles (31 , 32) joignant chacune un premier encastrement (41 , 42) d'un premier élément (4) à un deuxième encastrement (51 , 52) d'un deuxième élément (5), au moins un deuxième couple (22) comportant deux autres lames flexibles (33 , 34) joignant chacune, d'une part un encastrement primaire (43 , 44) dudit premier élément (4) ou un encastrement secondaire (53 , 54) dudit deuxième élément (5), à d'autre part un encastrement tertiaire (63, 64) que comporte un troisième élément (6) agencé pour être fixé solidairement à une structure fixe dudit résonateur (100), où lesdits, d'une part encastrements primaires (43, 44) dudit premier élément (4) ou encastrements secondaires (53, 54) dudit deuxième élément (5), et d'autre part lesdits encastrements tertiaires (63, 64) définissent deux directions secondaires de lames (DL3, DL4) formant ensemble un deuxième angle au sommet (β) au niveau d'un axe secondaire (B) défini par le croisement, en plan ou en projection, desdites directions secondaires de lames (DL3, DL4), ledit deuxième angle au sommet (β) étant compris entre 115° et 130°, bornes comprises, et dont la valeur en degrés satisfait la relation f1(X$_β$)<β<f2(X$_β$),
   avec f1(X$_β$)=108+67/(10X$_β$-6), et f2(X$_β$)=113+67/(10X$_β$-6), avec X$_β$=D3/L3=D4/L4,
   **caractérisé en ce qu'**une fonction médiane fm(X)= 110.5 + 67/(10X-6) définit un rapport intermédiaire entre une première fonction inférieure f1(X)= 108 + 67/(10X-6), et une
   première fonction supérieure f2(X)= 113 + 67/(10X-6), avec X= D/L, et **en ce que** ledit premier angle au sommet (α) et ledit deuxième angle au sommet (β) sont positionnés entre ladite première fonction inférieure f1 et ladite première fonction supérieure f2, de part et d'autre de ladite fonction médiane fm.

2. Pivot (1) selon la revendication 1, **caractérisé en ce que** ledit axe de pivotement théorique (A) est géométriquement situé dans ledit premier élément (4) ou dans ledit deuxième élément (5).

3. Pivot (1) selon la revendication 2, **caractérisé en ce que** ledit axe de pivotement théorique (A) est situé géométriquement dans un oeil (40 , 50) que comporte ledit premier élément (4) ou ledit deuxième élément (5).

4. Pivot (1) selon la revendication 3, **caractérisé en ce que** ledit premier élément (4) ou ledit deuxième élément (5) est un élément inertiel, et **en ce que** ledit axe de pivotement théorique (A) est situé géométriquement dans ledit oeil (40 , 50) que comporte ledit élément inertiel.

5. Pivot (1) selon l'une des revendications 1 à 4, **caractérisé en ce que** ledit premier élément (4) ou ledit deuxième élément (5) comporte une surface concave (74) agencée pour entourer à distance, sur au moins 180°, une surface convexe (75) que comporte ledit deuxième élément (5) ou respectivement ledit premier élément (4), avec, dans une position de repos dudit pivot (1), un jeu en tout point supérieur ou égal à un jeu de sécurité (J) entre ladite surface convexe (75) et ladite surface concave (74).

6. Pivot (1) selon l'une des revendications 1 à 5, **caractérisé en ce que** ledit premier élément (4) ou ledit deuxième élément (5) est un élément inertiel, et **en ce que** ledit troisième élément (6) comporte une surface interne (76) agencée pour entourer à distance, sur au moins 180°, une surface convexe (75) que comporte ledit élément inertiel, avec, dans une position de repos dudit pivot (1), un jeu en tout point supérieur ou égal à un jeu de sécurité (J) entre ladite surface convexe (75) et ladite surface interne (76).

7. Pivot (1) selon l'une des revendications 1 à 6, **caractérisé en ce que** lesdits axe de pivotement théorique (A) et axe secondaire (B) sont confondus.

8. Pivot (1) selon l'une des revendications 1 à 7, **caractérisé en ce que** ledit pivot (1) comporte au moins un desdits couples (21, 22) comportant deux lames flexibles (31, 32 ; 33, 34) qui sont, ou bien identiques en symétrie par rapport à un plan de symétrie passant par ledit axe de pivotement théorique (A) quand lesdites deux lames flexibles sont coplanaires, ou bien identiques en symétrie en projection sur un plan de référence parallèle auxdites deux lames flexibles quand lesdites deux lames flexibles se développent sur deux niveaux parallèles audit plan de référence mais ne sont pas coplanaires, par rapport à un plan de symétrie passant par ledit axe de pivotement théorique (A).

9. Pivot (1) selon la revendication 8, **caractérisé en ce que** chaque dit couple (21, 22), que comporte ledit pivot (1), comporte deux lames flexibles (31, 32 ; 33, 34) qui sont, ou bien identiques en symétrie par rapport à un plan passant par ledit axe de pivotement théorique (A) quand lesdites deux lames flexibles sont coplanaires, ou bien identiques en symétrie en projection sur un plan de référence parallèle auxdites deux lames flexibles quand lesdites deux lames flexibles se développent sur deux niveaux parallèles audit plan de référence mais ne sont pas coplanaires.

10. Pivot (1) selon l'une des revendications 1 à 9, **caractérisé en ce que** ledit pivot (1) comporte au moins un desdits couples (21, 22) comportant deux lames flexibles (31, 32 ; 33, 34) qui sont coplanaires.

11. Pivot (1) selon l'une des revendications 1 à 9, **caractérisé en ce que** ledit pivot (1) comporte au moins un desdits couples (21, 22) comportant deux lames flexibles (31, 32 ; 33, 34) qui se développent sur deux niveaux parallèles audit plan de référence mais ne sont pas coplanaires.

12. Pivot (1) selon la revendication 10, **caractérisé en ce que** ledit pivot (1) comporte au moins un desdits couples (21, 22) comportant deux lames flexibles (33, 34 ; 31, 32) qui se développent sur deux niveaux parallèles audit plan de référence mais ne sont pas coplanaires.

13. Résonateur (100) comportant ledit premier élément (4) et ledit deuxième élément (5) joints par au moins ledit couple (21, 22) comportant lesdites deux lames flexibles (31, 32 ; 33, 34) que comporte ledit pivot (1) selon l'une des revendications 1 à 12, **caractérisé en ce que** le centre de masse dudit résonateur (100) dans sa position de repos est distant dudit axe de pivotement théorique (A) d'un écart ($\epsilon$) qui est compris entre 0.8 fois et 1.2 fois la valeur ($2D^2/L$ - 1.6. D - 0.1 L), où D=D1=D2 et L=L1=L2.

14. Résonateur (100) selon la revendication 13, **caractérisé en ce que** ledit pivot (1) est symétrique, au moins en projection sur ledit plan de référence, par rapport à un plan de symétrie passant par ledit axe de pivotement théorique (A), et **en ce que** ledit centre de masse dudit résonateur (100) dans sa position de repos est situé géométriquement sur ledit plan de symétrie.

15. Mouvement d'horlogerie (1000) comportant au moins un résonateur (100) selon la revendication 13 ou 14.

16. Montre (2000) comportant un mouvement d'horlogerie (1000) selon la revendication 15.

**Patentansprüche**

1. Isochroner Drehzapfen (1) für einen Uhrwerkresonator (100) mit flexibler Führung, umfassend mindestens ein Paar (21), das zwei flexible Lamellen (31, 32) aufweist, die jeweils eine erste Einfassung (41, 42) eines ersten Elements (4) mit einer zweiten Einfassung (51, 52) eines zweiten Elements (5) verbinden, wobei die ersten Einfassungen (41, 42) mit den zweiten Einfassungen (51, 52) jeweils zwei Hauptrichtungen (DL1, DL2) der Lamellen definieren, wobei das erste Element (4) und das zweite Element (5) jeweils steifer als jede der flexiblen Lamellen (3) sind und von denen jedes in der Lage ist, ein bewegliches Trägheitselement innerhalb des Resonators (100) zu bilden, und wobei die beiden Hauptrichtungen (DL1, DL2) der Lamellen an ihrem Schnittpunkt eine theoretische Schwenkachse (A) definieren, wenn die beiden flexiblen Lamellen (31, 32) koplanar sind, oder am Schnittpunkt ihrer Projektionen auf einer Bezugsebene parallel zu den beiden flexiblen Lamellen (31, 32), wenn die beiden flexiblen Lamellen (31, 32) sich auf zwei Ebenen parallel zur Bezugsebene erstrecken, aber nicht koplanar sind, wobei jede flexible Lamelle (31, 32) eine freie Länge (L1, L2) zwischen ihren beiden Einfassungen (41, 51, 42, 52) und einen axialen Abstand (D1, D2) zwischen der theoretischen Schwenkachse (A) und derjenigen ihrer beiden Einfassungen (41, 51, 42, 52), die am weitesten entfernt liegt, aufweist, und wobei für jede der flexiblen Lamellen (31, 32) das Haupteinfassungsverhältnis (D1/L1, D2/L2) zwischen dem axialen Abstand und der freien Länge größer als eins ist, wobei die beiden Hauptrichtungen (DL1, DL2) der Lamellen mit der theoretischen Schwenkachse (A) einen ersten Scheitelwinkel definieren, dessen Wert in Grad die Beziehung $f1(X_\alpha) < \alpha < f2(X_\alpha)$ erfüllt, mit $f1(X_\alpha)=108+67/(10X_\alpha-6)$ und $f2(X_\alpha)=113+67/(10X_\alpha-6)$, mit $X_\alpha = D1/L1 = D2/L2$,

wobei die beiden Hauptrichtungen (DL1, DL2) der Lamellen mit der theoretischen Schwenkachse (A) einen ersten Scheitelwinkel definieren, der zwischen 115° und 130°, Grenzwerte eingeschlossen, liegt, und wobei der Drehzapfen (1) zusätzlich zu einem ersten Paar (21), das die beiden flexiblen Lamellen (31, 32) aufweist, die jeweils eine erste Einfassung (41, 42) eines ersten Elements (4) mit einer zweiten Einfassung (51, 52) eines zweiten Elements (5) verbinden, mindestens ein zweites Paar (22) umfasst, das zwei weitere flexible Lamellen (33, 34) aufweist, die jeweils einerseits eine primäre Einfassung (43, 44) des ersten Elements (4) oder eine sekundäre Einfassung (53, 54) des zweiten Elements (5) mit einer tertiären Einfassung (63, 64) andererseits verbinden, die ein drittes Element (6) aufweist, das so angeordnet ist, dass es an einer festen Struktur des Resonators (100) befestigbar ist, wobei einerseits die primären Einfassungen (43, 44) des ersten Elements (4) oder die sekundären Einfassungen (53, 54) des zweiten Elements (5) und andererseits die tertiären Einfassungen (63, 64), die zwei Sekundärrichtungen (DL3, DL4) definieren, zusammen einen zweiten Scheitelwinkel ($\beta$) in der Ebene einer Sekundärachse (B) bilden, die durch den Schnittpunkt in der Ebene oder in der Projektion der Sekundärrichtungen (DL3, DL4) der Lamellen definiert ist, wobei der zweite Scheitelwinkel ($\beta$) zwischen 115° und 130°, Grenzwerte eingeschlossen, liegt, dessen Wert in Grad die Beziehung $f1(X_\beta) < \beta < f2(X_\beta)$ erfüllt, mit $f1(X_\beta)=108+67/(10X_\beta-6)$ und $f2(X_\beta)=113+67/(10X_\beta-6)$, mit $X_\beta=D3/L3=D4/L4$, **dadurch gekennzeichnet, dass** eine Medianfunktion $fm(X) = 110,5 + 67/(10X-6)$ ein Zwischenverhältnis zwischen einer ersten unteren Funktion $f1(X) = 108 + 67/(10X-6)$ und einer ersten oberen Funktion $f2(X)= 113 + 67/(10X-6)$, mit $X = D/L$, definiert und dass der erste Scheitelwinkel und der zweite Scheitelwinkel ($\beta$) zwischen der ersten unteren Funktion f1 und der ersten oberen Funktion f2 auf beiden Seiten der Medianfunktion fm positioniert sind.

2. Drehzapfen (1) nach Anspruch 1, **dadurch gekennzeichnet, dass** die theoretische Schwenkachse (A) sich geometrisch im ersten Element (4) oder im zweiten Element (5) befindet.

3. Drehzapfen (1) nach Anspruch 2, **dadurch gekennzeichnet, dass** die theoretische Schwenkachse (A) sich geometrisch in einem Auge (40, 50) befindet, das das erste Element (4) oder das zweite Element (5) aufweist.

4. Drehzapfen (1) nach Anspruch 3, **dadurch gekennzeichnet, dass** das erste Element (4) oder das zweite Element (5) ein Trägheitselement ist und dass die theoretische Schwenkachse (A) sich geometrisch in dem Auge (40, 50) befindet, das das Trägheitselement aufweist.

5. Drehzapfen (1) nach einem der Ansprüche 1 bis 4, **dadurch gekennzeichnet, dass** das erste Element (4) oder das zweite Element (5) eine konkave Oberfläche (74) aufweist, die so angeordnet ist, dass sie in einem Abstand von mindestens 180° eine konvexe Oberfläche (75) umgibt, die das zweite Element (5) bzw. das erste Element (4) aufweist, wobei in einer Ruheposition des Drehzapfens (1) ein Spiel an jedem Punkt größer oder gleich einem Sicherheitsspiel (J) zwischen der konvexen Oberfläche (75) und der konkaven Oberfläche (74) vorhanden ist.

6. Drehzapfen (1) nach einem der Ansprüche 1 bis 5, **dadurch gekennzeichnet, dass** das erste Element (4) oder das zweite Element (5) ein Trägheitselement ist und dass das dritte Element (6) eine Innenfläche (76) aufweist, die so angeordnet ist, dass sie in einem Abstand von mindestens 180° eine konvexe Oberfläche (75) umgibt, die das Trägheitselement aufweist, wobei in einer Ruheposition des Drehzapfens (1) ein Spiel an jedem Punkt größer oder gleich einem Sicherheitsspiel (J) zwischen der konvexen Oberfläche (75) und der Innenoberfläche (76) vorhanden ist.

7. Drehzapfen (1) nach einem der Ansprüche 1 bis 6, **dadurch gekennzeichnet, dass** die theoretische Schwenkachse (A) und die Sekundärachse (B) zusammenfallen.

8. Drehzapfen (1) nach einem der Ansprüche 1 bis 7, **dadurch gekennzeichnet, dass** der Drehzapfen (1) mindestens eines der Paare (21, 22) aufweist, das zwei flexible Lamellen (31, 32; 33, 34) aufweist, die entweder in Bezug auf eine identische Symmetrieebene, die durch die theoretische Schwenkachse (A) verläuft, symmetrisch identisch sind, wenn die beiden flexiblen Lamellen koplanar sind, oder in der Projektion auf einer Bezugsebene parallel zu den beiden flexiblen Lamellen, wenn die beiden flexiblen Lamellen sich auf zwei Ebenen parallel zur Bezugsebene erstrecken, aber nicht koplanar sind, in Bezug auf eine Symmetrieebene, die durch die theoretische Schwenkachse (A) verläuft, symmetrisch identisch sind.

9. Drehzapfen (1) nach Anspruch 8, **dadurch gekennzeichnet, dass** jedes Paar (21, 22), das der Drehzapfen (1) umfasst, zwei flexible Lamellen (31, 32; 33, 34) aufweist, die entweder in Bezug auf eine Ebene, die durch die theoretische Schwenkachse (A) verläuft, wenn die beiden flexiblen Lamellen koplanar sind, symmetrisch identisch sind oder in der Projektion auf einer Bezugsebene parallel zu den beiden flexiblen Lamellen, wenn die beiden flexiblen Lamellen sich auf zwei Ebenen parallel zur Bezugsebene erstrecken, aber nicht koplanar sind, symmetrisch identisch sind.

10. Drehzapfen (1) nach einem der Ansprüche 1 bis 9, **dadurch gekennzeichnet, dass** der Drehzapfen (1) mindestens eines der Paare (21, 22) umfasst, die zwei flexible Lamellen (31, 32; 33, 34) aufweisen, die koplanar sind.

11. Drehzapfen (1) nach einem der Ansprüche 1 bis 9, **dadurch gekennzeichnet, dass** der Drehzapfen (1) mindestens eines der Paare (21, 22) umfasst, die zwei flexible Lamellen (31, 32; 33, 34) aufweisen, die sich auf zwei Ebenen parallel zur Bezugsebene erstrecken, aber nicht koplanar sind.

12. Drehzapfen (1) nach Anspruch 10, **dadurch gekennzeichnet, dass** der Drehzapfen (1) mindestens eines der Paare (21, 22) umfasst, die zwei flexible Lamellen (33, 34; 31, 32) aufweisen, die sich auf zwei Ebenen parallel zur Bezugsebene erstrecken, aber nicht koplanar sind.

13. Resonator (100), umfassend das erste Element (4) und das zweite Element (5), die durch mindestens das Paar (21, 22) verbunden sind, das die beiden flexiblen Lamellen (31, 32; 33, 34) aufweist, die der Drehzapfen (1) nach einem der Ansprüche 1 bis 12 umfasst, **dadurch gekennzeichnet, dass** der Massenschwerpunkt des Resonators (100) in seiner Ruheposition von der theoretischen Schwenkachse (A) um einen Abstand ($\varepsilon$), der zwischen dem 0,8-fachen und dem 1,2-fachen Wert von $(2D^2/L - 1{,}6D - 0{,}1L)$, wobei $D = D1 = D2$ und $L = L1 = L2$, liegt, entfernt ist.

14. Resonator (100) nach Anspruch 13, **dadurch gekennzeichnet, dass** der Drehzapfen (1) zumindest in der Projektion auf die Bezugsebene in Bezug auf eine Symmetrieebene, die durch die theoretische Schwenkachse (A) verläuft, symmetrisch ist und dass sich der Massenschwerpunkt des Resonators (100) in seiner Ruheposition geometrisch in der Symmetrieebene befindet.

15. Uhrwerk (1000), umfassend mindestens einen Resonator (100) nach Anspruch 13 oder 14.

16. Uhr (2000), umfassend ein Uhrwerk (1000) nach Anspruch 15.

**Claims**

1. Isochronous pivot (1) for a timepiece resonator (100), with a flexure bearing, comprising at least one pair (21) including two flexible strips (31, 32) each joining a first point of attachment (41, 42) of a first element (4) to a second point of attachment (51, 52) of a second element (5), said first attachment points (41, 42) defining, with said respective second attachment points (51, 52), two main strip directions (DL1, DL2), said first element (4) and said second element (5) each being stiffer than each of said flexible strips (3), and each able to form a movable inertial element inside a said resonator (100), and said two main strip directions (DL1, DL2) defining a theoretical pivot axis (A) at their intersection when said two flexible strips (31, 32) are coplanar, or at the intersection of their projections onto a reference plane parallel to said two flexible strips (31, 32) when said two flexible strips (31, 32) extend on two levels parallel to said reference plane but are not coplanar,each said flexible strip (31, 32) having a free length (L1, L2) between its two attachment points (41, 51, 42, 52), and having an axial distance (D1, D2) between said theoretical pivot axis (A) and whichever of its two attachment points (41, 51, 42, 52) is farthest therefrom, and wherein, for each said flexible strip (31, 32), the main attachment point ratio (D1/L1, D2/L2) between said axial distance and said free length is greater than one, wherein said two main strip directions (DL1, DL2) define with said theoretical pivot axis (A) a first apex angle whose value in degrees satisfies the relation $f1(X_\alpha) < \alpha < f2(X_\alpha)$, with $f1(X_\alpha) = 108 + 67/(10X_\alpha - 6)$, and $f2(X_\alpha) = 113 + 67/(10X_\alpha - 6)$, with $X_\alpha = D1/L1 = D2/L2$, wherein said two main strip directions (DL1, DL2) define with said theoretical pivot axis (A) a first apex angle comprised between 115° and 130° inclusive, and wherein said pivot (1) includes, in addition to a first pair (21) including said two flexible strips (31, 32), each joining a first attachment point (41, 42) of a first element (4) to a second attachment point (51, 52) of a second element (5), at least a second pair (22) including two other flexible strips (33, 34) each joining, on the one hand, a primary attachment point (43, 44) of said first element (4) or a secondary attachment point (53, 54) of said second element (5), to, on the other hand, a third attachment point (63, 64) comprised in a third element (6) arranged to be fixedly secured to a fixed structure of said resonator (100), wherein said primary attachment points (43, 44) of said first element (4) or secondary attachment points (53, 54) of said second element (5), on the one hand, and said tertiary attachment points (63, 64) on the other hand, define two secondary strip directions (DL3, DL4) together forming a second apex angle ($\beta$) at a secondary axis (B) defined by the intersection, in plane or in projection, of said secondary strip directions (DL3, DL4), said second apex angle ($\beta$) being comprised between 115° and 130° inclusive, and whose value in degrees satisfies the relation $f1(X_\beta) < \beta < f2(X_\beta)$, with $f1(X_\beta) = 108 + 67/(10 X_\beta - 6)$, and $f2(X_\beta) = 113 + 67/(10 X_\beta - 6)$, with $X_\beta = D3/L3 = D4/L4$, **characterised in that** a median function $fm(X) = 110.5 + 67/(10X-6)$ defines an intermediate ratio between said first lower function $f1(X) = 108 + 67/(10X-6)$, and said first upper function $f2(X) = 113 + 67/(10X-6)$, with X = D/L, and **in that** said first apex angle and said second apex angle ($\beta$) are positioned between said first lower function f1 and said first upper function f2, on either side of said median function fm.

2. Pivot (1) according to claim 1, **characterised in that** said theoretical pivot axis (A) is geometrically located in said first element (4) or in said second element (5).

3. Pivot (1) according to claim 2, **characterised in that** said theoretical pivot axis (A) is geometrically located in an eye (40, 50) comprised in said first element (4) or said second element (5).

4. Pivot (1) according to claim 3, **characterised in that** said first element (4) or said second element (5) is an inertial element, and **in that** said theoretical pivot axis (A) is geometrically located in said eye (40, 50) comprised in said inertial element.

5. Pivot (1) according to one of claims 1 to 4, **characterised in that** said first element (4) or said second element (5) includes a concave surface (74) arranged to surround at a distance, over at least 180°, a convex surface (75) comprised in said second element (5) or said first element (4) respectively, with, in a rest position of said pivot (1), a clearance which, at every point, is greater than or equal to a safety clearance (J) between said convex surface (75) and said concave surface (74).

6. Pivot (1) according to one of claims 1 to 5, **characterised in that** said first element (4) or said second element (5) is an inertial element, and **in that** said third element (6) includes an internal surface (76) arranged to surround at a distance, over at least 180°, a convex surface (75) comprised in said inertial element, with, in a rest position of said pivot (1), a clearance which, at every point, is greater than or equal to a safety clearance (J) between said convex surface (75) and said internal surface (76).

7. Pivot (1) according to one of claims 1 to 6, **characterised in that** said theoretical pivot axis (A) and secondary axis (B) are coincident.

8. Pivot (1) according to one of claims 1 to 7, **characterised in that** said pivot (1) includes at least one of said pairs (21, 22) including two flexible strips (31, 32; 33, 34), which are either identical in symmetry with respect to a plane of symmetry passing through said theoretical pivot axis (A) when said two flexible strips are coplanar, or identical in symmetry in projection onto a reference plane parallel to said two flexible strips when said two flexible strips extend on two levels parallel to said reference plane but are not coplanar, with respect to a plane of symmetry passing through said theoretical pivot axis (A).

9. Pivot (1) according to claim 8, **characterised in that** each said pair (21, 22) comprised in said pivot (1), includes two flexible strips (31, 32; 33, 34), which are either identical in symmetry with respect to a plane passing through said theoretical pivot axis (A) when said two flexible strips are coplanar, or identical in symmetry in projection onto a reference plane parallel to said two flexible strips when said two flexible strips extend on two levels parallel to said reference plane but are not coplanar.

10. Pivot (1) according to one of claims 1 to 9, **characterised in that** said pivot (1) includes at least one of said pairs (21, 22) including two flexible strips (31, 32; 33, 34) which are coplanar.

11. Pivot (1) according to one of claims 1 to 9, **characterised in that** said pivot (1) includes at least one of said pairs (21, 22) including two flexible strips (31, 32; 33, 34), which extend on two levels parallel to said reference plane but are not coplanar.

12. Pivot (1) according to claim 10, **characterised in that** said pivot (1) includes at least one of said pairs (21, 22) including two flexible strips (33, 34; 31, 32), which extend on two levels parallel to said reference plane but are not coplanar.

13. Resonator (100) including a first element (4) and a second element (5), joined by at least said pair (21, 22) including said two flexible strips (31, 32; 33, 34) comprised in said pivot (1) according to one of claims 1 to 12, **characterised in that** the centre of mass of said resonator (100) in its rest position is separated from said theoretical pivot axis (A) by a distance ($\varepsilon$) which is comprised between 0.8 times and 1.2 times the value ($2D^2/L$ - 1.6. D - 0.1 L), where D=D1=D2 and L=L1=L2.

14. Resonator (100) according to claim 13, **characterised in that** said pivot (1) is symmetrical, at least in projection onto said reference plane, with respect to a plane of symmetry passing through said theoretical pivot axis (A), and **in that** the centre of mass of said resonator (100) in its rest position is geometrically located on said plane of symmetry.

15. Timepiece movement (1000) including at least one resonator (100) according to claim 13 or 14.

16. Watch (2000) including a timepiece movement (1000) according to claim 15.

# Fig. 1A

# Fig. 1B

# Fig. 2

# Fig. 3

Fig. 4

Fig. 5

Fig. 6

Fig. 7

## Fig. 8

## Fig. 9

## Fig. 10

**EP 3 451 072 B1**

## RÉFÉRENCES CITÉES DANS LA DESCRIPTION

**Documents brevets cités dans la description**

- EP 3035126 A1
- EP 3206089 A1
- EP 14199039 A